(19) Europäisches Patentamt / European Patent Office / Office européen des brevets

(11) **EP 2 746 784 B1**

(12) **EUROPEAN PATENT SPECIFICATION**

(45) Date of publication and mention
of the grant of the patent:
**09.12.2020 Bulletin 2020/50**

(51) Int Cl.:
***G01R 19/155*** *(2006.01)*   ***G01R 19/25*** *(2006.01)*

(21) Application number: **13396003.9**

(22) Date of filing: **31.01.2013**

(54) **A sensor for indicating voltage in a power transmission line and a method for voltage sensing**

Sensor zum Anzeigen der Spannung einer Energieübertragungsleitung und Verfahren zum Messen einer Spannung

Capteur pour indiquer la tension d'une ligne de transmission d'énergie et procédé pour mesurer une tension

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **04.09.2012  FI 20120293**
**22.01.2013  FI 20130014**

(43) Date of publication of application:
**25.06.2014  Bulletin 2014/26**

(73) Proprietors:
• **Eltel Networks Oy**
  **02650 Espoo (FI)**
• **Domax Oy**
  **10600 Tammisaari (FI)**

(72) Inventors:
• **Raatikainen, Janne**
  **02770 Espoo (FI)**
• **Maksniemi, Matti**
  **10600 Tammisaari (FI)**

(74) Representative: **Pirhonen, Kari Lennart**
**Patenttitoimisto Kari Pirhonen Oy**
**P.O. Box 71**
**20101 Turku (FI)**

(56) References cited:
WO-A2-98/59251    DE-A1- 2 418 622
DE-A1- 2 846 674    US-A- 3 296 494
US-A- 3 546 587    US-A- 5 859 597

**Description**

OBJECT OF THE INVENTION

The object of the present invention is a remote detector for voltage detection in an electrical grid, by which remote detector it can be established whether a voltage is present in a conductor of the electrical grid.

PRIOR ART

The conductors in high-voltage electrical grids commonly have a voltage ranging from 10 kV to 400 kV. Because such extreme voltages, i.e. high voltages, cause a danger to human life, the safety of an electrician must absolutely be verified before undertaking any installation or repair work on the electrical grid. It is essential for safety at work that, prior to starting any work in connection with the electrical conductor, the absence of voltage is established and verified so that safe work is possible.

The detection of high voltages is, however, problematic. According to a known method, the absence of voltage in a high-voltage conductor is established and verified by means of a device at the end of a long rod which is used to touch the conductor. The equipment in use requires the user to climb up the tower, which always creates a safety risk, and using this equipment is slow. In addition, two persons should be present to verify safety.

The apparatus currently in use, the only one proven reliable, weighs approximately 2 kg. Carrying and taking out the apparatus in the field and even holding it in the hand is cumbersome. As each instance of measurement and voltage detection requires the electrician to climb up, for example, a transmission tower as high as 40 m, the detection of voltage in an electrical conductor is extremely cumbersome and slow. The situation is also exacerbated by the fact that the field kit of an electrician usually consists of 5 to 20 kg of tools, materials and safety equipment, depending on the situation.

Touching a high voltage conductor cannot be regarded as a solution either, because it always entails a safety risk. Thus there is a need to establish the voltage of an electrical conductor in another way. However, there is no quick and reliable measurement apparatus fit for work in the field available.

In prior art the following documents present known solutions for voltage detection: WO98/59251, DE2418622A1, US5859597A, US3296494A, US3546587A and DE2846674A1.

PURPOSE OF THE INVENTION

The purpose of this invention is to create an apparatus that does not have the above-mentioned drawbacks. Furthermore, the purpose of the invention is also to create a safe apparatus for detecting and/or recognising an electrical potential difference, i.e. voltage.

CHARACTERISTICS OF THE APPARATUS

An apparatus according to the invention is characterised in what is described in the characterizing part of claim 1. The remote detector for voltage detection in an electrical grid comprises a sensor with which sensor the voltage of a high-voltage electrical conductor can be detected at a distance from the electrical conductor without having to touch the electrical conductor.

The apparatus is small in size and lightweight, and it can be switched on all the time when so required. In this way the remote detector for voltage detection can be used for many new applications, such as inspections in the field, engineering work as well as installation, maintenance and repair work on electrical distribution and transmission grids on land, at sea, and on railways.

By means of an apparatus according to the invention, the voltage of an electrical conductor can be remotely detected without touching the conductor, at a distance of up to 30 m from the electrical conductor, depending on the voltage. In this case the electrician does not have to climb up the transmission tower. The measurement is carried out either when the electrician is on the ground or, if necessary, up on the transmission tower when one is required to establish the presence of voltage in an individual conductor or electrical phase. Measurements can also be carried out aboard a moving vehicle on land, on water or in the air.

The measurement process of an apparatus according to the invention is very rapid, usually taking approximately 10 seconds. There are multiple possibilities for signal processing and indicating its strength, and for alarms. The apparatus can be modified for application in connection with a safety glove or an active safety helmet, for example. By means of the apparatus, limits can also be set, for example, for the height of a truck bed, so that the truck bed cannot be raised too high under power lines. Raising a truck bed close to electrical conductors always entails a safety risk.

An apparatus according to the invention is small, light in weight and economical to manufacture. Most advantageously, commonly available electronic components are used in it, making the apparatus simple and reliable and unsusceptible to break down even when handled roughly. The apparatus is convenient and easy to carry along, thus promoting work safety. This also makes the method of voltage detection in field conditions significantly easier and more effective because voltage indication for the conductors is already obtained when approaching the conductors, on the ground.

It is important in the maintenance of transmission towers to be able to distinguish between live and dead conductors when working close to the border between the safe distance and the danger zone. Also in any other maintenance situation, such as prior to the connection of temporary worksite earthing, when building, maintaining and dismantling it, it is important to know of any voltages present in the conductors.

The apparatus can also be used by electricians, repair personnel and rescue services, for example on 25 kV electrified railway lines. The voltage of a high-voltage grid right-of-way can be detected and measured even from a helicopter.

A remote detector and/or sensor according to the invention can also be connected to a piece of electrician's equipment, such as clothing, a glove or a helmet. Because electricians work on high-voltage grids in extreme height and weather conditions, which necessitate the use of heavy equipment in any case, combining a remote detector with the electrician's or rescue service member's equipment reduces the amount of separate devices to be carried along.

When approaching conductors in maintenance work on transmission towers, a remote detector for voltage detection that is always carried along readily establishes the presence of voltage in a conductor already on the ground, which makes it possible to keep an appropriate safe distance from a live conductor. It is also important to be able to distinguish between live and dead conductors when working in the vicinity of a live conductor. This is particularly important when there are several transmission lines present at the work site, such as a number of 110 to 400 kV power lines side by side or on the same tower.

A remote detector and/or sensor according to the invention can also be connected to a vehicle, such as a truck, crane or personnel lift, in such a way that the remote detector gives a safe distance alarm when the vehicle is steered into the vicinity of an electrical conductor. It has been established that, for example, raising the bed of a truck close to an electrical conductor poses a hazard of electric shock.

The remote detector according to the invention allows the selection of a suitable voltage and/or sensitivity for establishing the presence of voltage in a high-voltage conductor. The functions of the selector switch and the programmable logic controller (PLC) part of the apparatus are described hereinafter. The sensor of the remote detector comprises two parallel and essentially equally-sized metal surfaces, between which metal surfaces a signal is generated by the voltage produced in the vicinity of a live high-voltage conductor, which signal enables the voltage present in the high-voltage conductor to be detected. Most advantageously, the two parallel metal surfaces in the sensor are arranged on the opposite sides of the same circuit board.

## METHOD

The object of the invention furthermore is a method for voltage detection in an electrical grid. By means of this method it can also be established whether a voltage is present in an electrical conductor of a high-voltage electrical grid.

## CHARACTERISTICS OF THE METHOD

A method according to the invention is characterised in what is described in the characterizing part of claim 5. To detect the presence of a voltage in a high-voltage electrical conductor of a high-voltage electrical grid, a remote detector is brought into the vicinity of the electrical conductor, at a distance from the electrical conductor, however in such a way that the distance of the remote detector from the electrical conductor is greater than the required safe distance and that, by means of the signal provided by the sensor of the remote detector, it is be detected at a distance from the high-voltage electrical conductor whether a voltage is present in the high-voltage electrical conductor, without having to touch the electrical conductor.

Thus the voltage in a high-voltage electrical grid is detected and recognised at a distance from the electrical conductor by using the remote detector, in such a way that the voltage range of the remote detector is adjusted to correspond to the voltage in the high-voltage conductor. The voltage in the high-voltage electrical grid can also be detected and recognised at a distance from the electrical conductor by using the remote detector in such a way that the sensitivity of the remote detector is set to correspond to the voltage in the high-voltage conductor.

According to the invention, the voltage in the high-voltage conductor is detected by utilising the capacitance principle in an inverted manner, such that a sensor where the signal is generated by the voltage produced between two parallel and essentially equally-sized metal surfaces is used in the vicinity of a live high-voltage conductor, whereby the voltage present in the high-voltage conductor is detected.

USAGE

According to the invention, the remote detector for voltage detection detects the voltage remotely, at a distance of approximately 2 to 25 m from the electrical conductor. The measurement process of the apparatus is rapid, approximately 10 seconds, and measurements can also be carried out aboard a moving vehicle or a helicopter. The apparatus is small, light in weight and economical. It is no longer necessary for an electrician to climb up a tall transmission tower, as in the known method, because it is possible, already on the ground, to detect whether a voltage is present in a conductor on the tower. If so required, the measurement can also be carried out up on the transmission tower to detect the presence of a voltage in a particular phase conductor. Such a situation may occur, for example, when a fault in a 20 kV transmission grid consisting of several conductors has to be investigated. An apparatus according to the invention is very small and can easily be carried along, making it quicker and more efficient to detect voltages even in field conditions. The good usability of the apparatus guarantees that it is always included in the kit and is in fact used, whereby safety at work is also improved.

The remote detector for voltage detection detects the presence of a voltage in an electrical conductor at a distance as follows. The electrician holds the apparatus in the hand or at the end of an electrically non-conductive rod, and the apparatus gives an alarm on the basis of a threshold distance and the measured voltage. The alarm may, for example, be given in the form of a sound and/or bright LED light and/or vibration.

Advantageously, the remote detector for voltage detection has three high-voltage ranges, i.e. 20 kV, 110 kV and 400 kV, and a single self-test voltage range 230 V. The apparatus has two control knobs each having four positions. The first control knob, i.e. the voltage selector switch, has a power-off position and voltage range positions 20 kV, 110 kV and 400 kV. The voltage range position 20 kV doubles as a 230 V self-test position at which position the apparatus alarms at all voltages. The other control knob, i.e. the sensitivity adjustment switch, comprises the sensitivity setting with four sensitivity ranges A, B, C and D. The apparatus is powered by a rechargeable battery.

A remote detector for voltage detection according to the invention was tested in two different ways. First, the apparatus was moved to different distances of 2 m, 4 m, 6 m, 8 m, 10 m, 12 m and 13 m from an electric conductor, and the measurement results at various voltages were documented. The apparatus operated faultlessly at the distances of 2 to 13 m from the electrical conductor, for example with a phase voltage of 325 kV, corresponding to a three-phase line voltage of 563 kV. Subsequently, in another measurement, the apparatus was stationary at a distance of 8.4 m from the electrical conductor, and the voltage was varied steplessly over a range from 0.6 kV to 325 kV.

STRUCTURE OF THE APPARATUS

A remote detector for voltage detection according to the invention has, for example, two operating switches and two LED signal lights. Their operation is described hereinafter.

The first switch, i.e. the voltage selector switch, is simultaneously the power on/off switch of the apparatus and a selector switch for three voltage ranges to be measured. The four positions of this switch are as follows.

> 0 = OFF Power is switched off. In the other positions, the power is switched on.
> 1 = 20 kV This position is simultaneously the self-test position of the apparatus.
> 2 = 110 kV
> 3 = 400 kV

The other switch, i.e. the sensitivity adjustment switch, is used for selecting the sensitivity setting of the apparatus. Its four positions A, B, C and D set the sensitivity of the apparatus as follows.

> A = the most sensitive position of the apparatus for measurements made at a long distance
> B = the second most sensitive position of the apparatus for measurements made at a fairly long distance, but somewhat closer
> C = the third most sensitive position of the apparatus for measurements made at a fairly short distance
> D = the least sensitive position of the apparatus for measurements at a short distance

The apparatus also has two small LED lights positioned side by side for indicating the status of the apparatus itself, the meaning of which statuses is as follows.

Green LED = the apparatus is ready for operation
Red LED = the voltage of the battery of the apparatus is too low, the battery needs to be recharged using the recharger of the apparatus.

There is a large red LED light on the bottom of the apparatus which lights up to indicate the measured field of voltage. This also triggers the buzzer and vibration alarm device of the apparatus.

According to the user instructions of an apparatus according to the example, the remote detector for voltage detection is tested before use as follows.

1. The apparatus is switched on by turning the first switch, i.e. the voltage selector switch, from position "0" to position "1".

2. The apparatus carries out a self-test lasting approx. 5 to 10 seconds. The buzzer, vibration alarm device and the large red LED light are on during the test. A small green LED light lights up when the test is completed.

3. During the test stage, the apparatus tests its own integrated circuits, idle voltages and the internal reference voltage.

4. In the field, the operation of the apparatus can further be tested in such a way that the voltage selector switch is set to position "1", the sensitivity adjustment switch is set to position "A" and the apparatus is brought under a 20 kV, 110 kV or 400 kV high-voltage conductor. In this case the apparatus causes an alarm to be set off in practice in the vicinity of any high-voltage conductors.

5. Indoors, the apparatus can also be tested in such a way that the voltage selector switch is set to position "1" and the apparatus is placed at a distance of approximately 3 to 5 cm from a 230 V alternating current conductor.

6. The voltage of the battery is constantly monitored and when it falls below a pre-set threshold voltage the apparatus lights up a small red LED to signal the battery-low status. The apparatus is not reliable in this condition and should be recharged before use.

When the test stages 1 to 4 are completed the remote detector for voltage detection is ready for use. Operation is started as follows.

The voltage selector switch is used to select a voltage range, "1" = 20 kV, "2" = 110 kV or "3" = 400 kV, according to the voltage expected in the conductor to be measured. The sensitivity adjustment switch is first set to the sensitivity range "A", i.e. the most sensitive position for measurements at a long distance. The sensitivity ranges "A" and "B" are intended to be used when working at a long distance from the electrical conductor, and the sensitivity ranges "C" or "D" for work close to the electrical conductor.

The voltage ranges "1" and "2" of the voltage selector switch can also be used within the range of a 400 kV high-voltage conductor, for instance, but in such a case the distances do not comply with the sensitivity range. The apparatus will not break down, however, if the voltage selector switch is set for example to position "2" when the electrical conductor has a voltage of, for example, 400 kV.

It is always possible initially to choose the selector switch position "1" for the voltage range and position "A" for the sensitivity range, whereby the apparatus has the most sensitive settings possible. If the settings of the apparatus are too sensitive when set in this way, the sensitivity range "B", "C" or "D" should be selected. After this, selection can made as follows: voltage range "2" and sensitivity range "A", "B" or "C", or further, voltage range "3" and sensitivity range "A", "B" or "C".

The environment, stray voltages, metal structures and a neutral conductor, for example, below 20 kV phase conductors, may dampen the voltage field to be measured and can thus have some impact on the operation of the apparatus.

The remote detector for voltage detection is primarily intended to be handheld, but it can also very well be attached to anything else, such as the end of an electrically non-conductive rod, the clothing or equipment of an electrician or a vehicle to be used.

The various positions of the voltage range and sensitivity adjustment switches for different measurement distances described above and to be used in the remote detector for voltage detection are as follows.

| Distance [m] | "1" 230 V | "1" 20 kV | "2" 110 kV | "3" 400 kV |
|---|---|---|---|---|
| 20+ | | | | A |
| 20 | | | A | B |
| 12 | | A | B | C |
| 8 | | B | C | D |
| 4 | | C | D | |
| 2 | | D | | |
| 0.01 (test) | A | | | |

The characteristics of a detector for voltage detection according to the invention comprise the following, for example:

1. The strength of electric flux can be detected over a distance and also close by without touching the conductor. With a voltage of 0.1 to 400 kV, the distance of the apparatus from the electrical conductor may range approximately between 0.005 m and 30 m. The signal is measured when walking on the ground or by climbing up the utility pole or the transmission tower. The signal required by the apparatus can be obtained aboard a moving vehicle at speeds ranging between 1 km/h and 160 km/h, when moving on water or in the air above the electrical conductors, for example during observation from a helicopter.

2. The voltage detector obtains the necessary signal without having to earth the apparatus. The apparatus can thus be held in any position. It is not necessary to directly aim the apparatus towards the power line. The electrically conductive surfaces on the opposite sides of the same circuit board function as the sensor in the apparatus, the surfaces being most advantageously coated with copper or another electrically conductive material. The apparatus:

- indicates a weak signal, which is matched and amplified,
- processes the signal by rectification and integration,
- further processes the integrated signal in a continuous measurement mode,
- has a standardised reference voltage for comparison with the signal and monitoring of the battery voltage.

3. One or more of the following elements are used for indicating the measurements and alarms: LED light, vibration device, buzzer, LED light column, digit display or a device showing any other corresponding pattern.

4. The apparatus comprises control switches and indication devices for indicating the magnitude of a voltage field, and devices for signalling alarms.

5. Most advantageously, the apparatus is held in the hand or in a pocket since the dimensions of the apparatus enclosure are small, most advantageously approximately 90 mm x 50 mm x 25 mm. Furthermore, the apparatus has light weight, most advantageously less than 50 g.

6. Operation of the apparatus is most advantageously effected as follows:

- without any computer software or, alternatively, assisted by computer software,
- the apparatus comprises at least one double-sided circuit board,
- commonly available electronic components are used for the assembly of the apparatus,
- reliable switches and/or controllers are used in the apparatus,
- the apparatus is easy and uncomplicated to use.

7. The apparatus comprises a sensor part and a PLC part. The sensor part and an additional signal amplifier part, if any, may be separated from the PLC part if so required, for example when:

- at least a part of apparatus is in the hand, in a pocket, on a vehicle or at the end of a test rod,
- the sensor is on the back of a work glove and the PLC part, for example, in the breast pocket of the user,
- the sensor is at the highest point of the bed of a truck and the PLC part elsewhere in the truck,
- the apparatus is used for remotely detecting power lines, for example when observing the condition of power lines from the air by means of a helicopter.

8. When the sensor part and the PLC part are combined or separated from one another, the functioning of the apparatus may be made more efficient by connecting it to:

- a GPS device,
- at least one additional display in addition to the LED lights or instead of them,
- a more efficient alarm indication device
- a contactor or another corresponding device that may be used for amplifying the control pulse.

In the following, the invention is described using examples with reference to the appended drawings, in which

LIST OF FIGURES

Fig. 1                  shows a schematic view of the minimum distances from high-voltage conductors to be applied by working personnel.

Fig. 2A                 shows a side view of a remote detector for voltage detection according to the invention.

Fig. 2B                 shows a view from above of the remote detector in Fig. 2A.

Fig. 3                  shows a side view of the remote detector for voltage detection.

Figures 4 and 5         illustrate diagrammatically measurement results of the remote detector for voltage detection.

Figures 6A and 6B       illustrate diagrammatically the principle of measurement based on capacitance.

Fig. 7                  shows a flow chart of the operation of the remote detector.

Fig. 8                  shows the circuit diagram of the remote detector.

Figures 9 and 10        show the different sides of the circuit board of the remote detector.

Fig. 11                 shows the structure of the remote detector on the first side of the circuit board.

Fig. 12                 shows the structure of the remote detector on the other side of the circuit board.

DESCRIPTION OF THE FIGURES

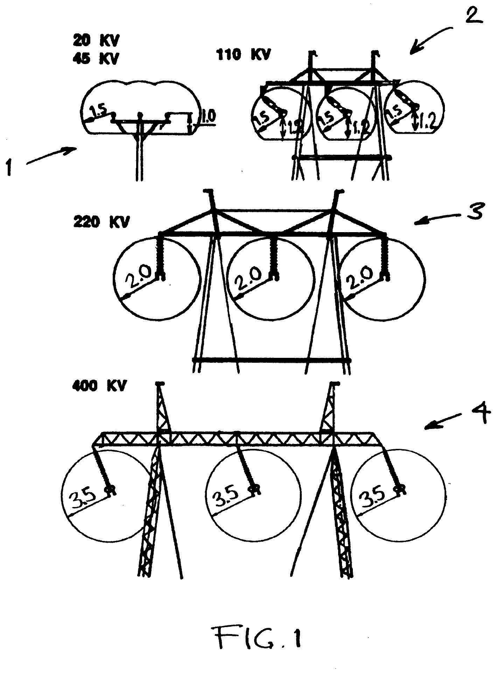

Fig. 1 shows a schematic view of the minimum distances from high-voltage conductors of different voltages to be applied by working personnel. From Fig. 1 it can be seen that electrical grids 1 and 2, with voltages of 20 kV, 45 kV or 110 kV, require a safe distance of 1.5 m from the electrical conductor. In electrical grid 3, where the voltage is 220 kV, the required safe distance from the electrical conductor is 2 m, and in the 400 kV electrical grid 4, the required safe distance from the electrical conductor is 3.5 m. As it is clear that a high-voltage conductor should not be approached, it is necessary to be able to detect the voltage in the conductor remotely. This is possible by means of a remote detector for voltage detection according to the invention.

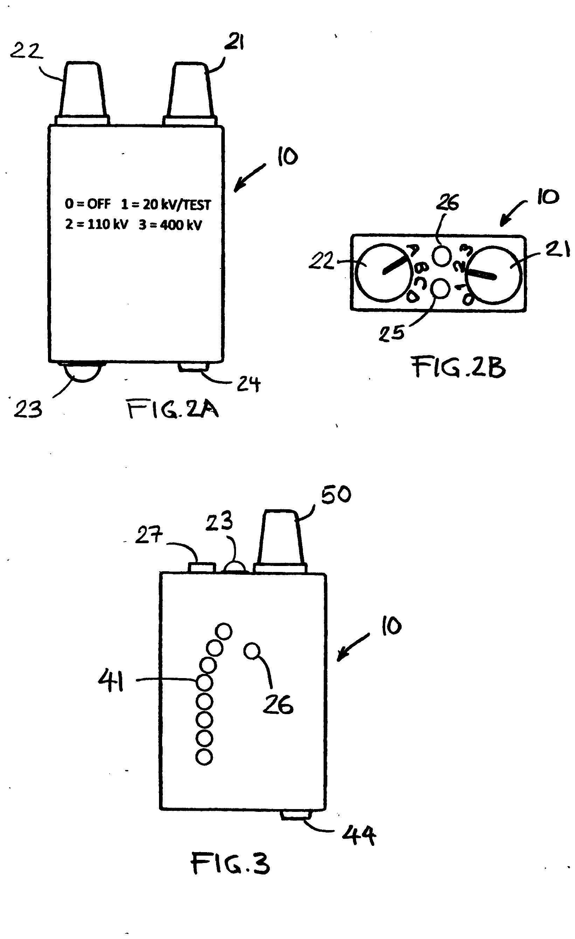

Fig. 2A on shows a remote detector 10 for voltage detection according to the invention, being comprised of a voltage selector switch 21, whereby the apparatus can be switched on and off and one of three different voltage ranges to be measured can be selected . Next to the voltage selector switch 21, in the upper part of the remote detector 10, there is a sensitivity adjustment switch 22, whereby one of the four sensitivity ranges of the apparatus can be selected. The apparatus furthermore comprises a red LED alarm light 23, which alarm light operates jointly with the buzzer alarm and vibration alarm of the apparatus when the remote detector 10 detects a voltage present in an electrical conductor. The battery of the apparatus is recharged by means of a battery recharge socket 24.

Fig. 2B shows a view from above of the remote detector 10 for voltage detection in Fig. 2A. In Fig. 2B it can be seen that the voltage selector switch 21 can be turned to one of four positions 0, 1, 2 or 3, wherein "0" is the power off position. In the other positions of the selector switch 21, power is switched on. Position "1" is the 20 kV measurement position and also the self-test position of the apparatus. Position "2" is the 110 kV measurement position, and position "3" is the 400 kV measurement position.

Fig. 2B also shows the sensitivity adjustment switch 22 which switch can be turned to any one of four positions A, B, C or D. Of these positions, "A" is the most sensitive one and intended for measurements from a long distance, and "D" is the least sensitive position of the apparatus, intended for measurements close to the object. The other positions B and C of the sensitivity adjustment switch 22 fall between A and D in terms of sensitivity. Fig. 2B further shows LED lights 25 and 26 on top of the remote detector 10, of which lights the green LED light 25 indicates that the apparatus is in working order and the red LED light 26 indicates that the voltage in the battery of the apparatus is so low that the battery requires recharging.

Fig. 3 shows a side view of the remote detector 10 for voltage detection in the upper part of which detector there is only a single selector switch 50, a power on/off switch 27 and a red LED light 23 for indicating the measured voltage field. The power on/off switch 27 protrudes approximately 4 mm out of the end when power is switched off, and power is switched on by pressing the power on/off switch 27 down. The power on/off switch 27 is additionally combined with a green LED light for status indication, which light indicates that the remote detector 10 is in working order.

On the side of the remote detector apparatus shown in Fig. 3, there is a LED light column 41 formed by eight LED lights in a line, wherein the lowest LED light is yellow and the others are red. These LED lights light up according to the strength of the alarm signal. The lowest LED light is yellow and the others are red. The yellow LED light indicates low magnitudes of the field, and it is used for daily testing of the apparatus, in such a way that, for example, the apparatus is brought to a distance of approximately 0.01 m from a live 230 VAC electrical conductor. There is furthermore a red LED light 26 on the side of the apparatus, next to the LED light column 41, for indicating low battery voltage.

The alarm threshold setting 36 of the remote detector 10 is selected by using the selection switch 50 to select a reference voltage with which voltage the signal level is compared in continuous mode. The reference voltages scan the distance to the high-voltage electrical conductor. As the voltage field strengthens on approaching the electrical conductor, or as the voltage increases, several LED lights light up simultaneously.

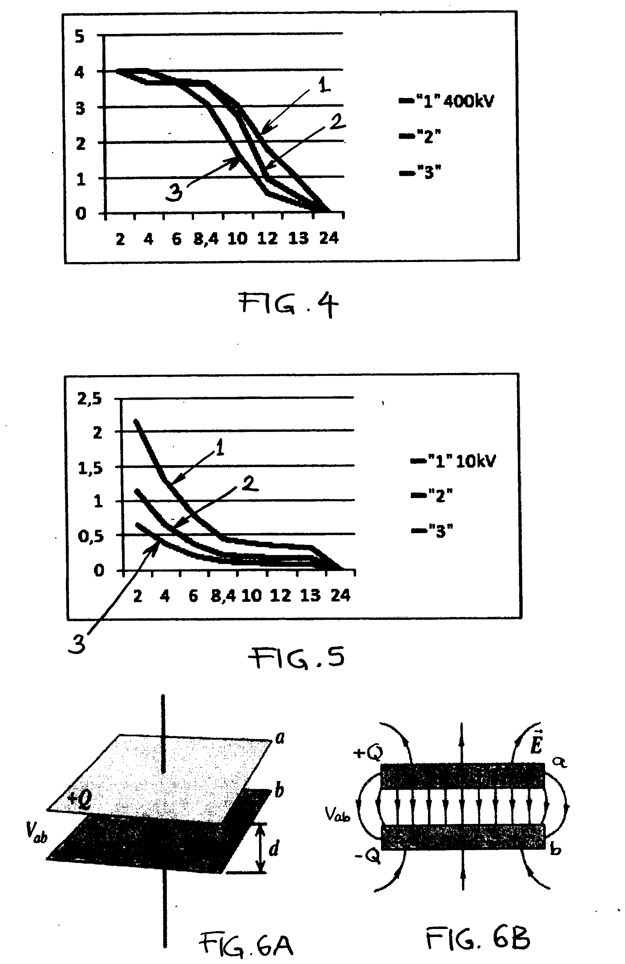

Figures 4 and 5 show measurement results from a remote detector for voltage detection according to the invention at voltages of 10 kV and 400 kV. The curves 1, 2 and 3 in Fig. 4 show measurement results from the vicinity of 400 kV live high-voltage conductor when measured with the voltage selector switch 22 at positions 1 = 20 kV, 2 = 110 kV and 3 = 400 kV and as the apparatus was moved to distances of 2 m, 4 m, 6 m, 8 m, 10 m, 12 m and 13 m from the electrical conductor. It can be seen in Fig. 4 that the curves of the signal of the remote detector obtained at the various voltage range positions 1, 2 and 3 essentially correspond with one another.

In the measurement shown in Fig. 5, the remote detector for voltage detection according to the invention was stationary at a distance of 8.4 m from an electrical conductor, and the voltage of the electrical conductor was steplessly varied between 4.1 kV and 325 kV. Fig. 5 shows that the curves of the signal of the remote detector obtained as a measurement result at the various sensitivity ranges are essentially of similar shape. Only their location in the graph changed as the sensitivity was adjusted.

Figures 6A and 6B illustrate schematically the capacitance phenomenon that, according to the invention, is utilised in a novel way to detect an electric field generated by a high-voltage conductor. When two metal plates a and b of equal size are placed in the electric field generated by a high-voltage conductor at a distance d from each other, a potential difference $V_{ab}$ is created between the plates. This voltage indicates the voltage present in the high-voltage conductor. In this way the known capacitance phenomenon is utilised according to the invention in a novel, unexpected manner.

In a relatively large and continuous electric field, a potential difference is generated between the two metal plates in proximity with each other. Furthermore, according to the invention, the potential difference of the plates is processed so as to comprise a significant indication. In this way the metal plates are used as a voltage-detecting sensor in a remote detector apparatus according to the invention. As the voltage or the distance between the apparatus and the electrical conductor changes, the sensor detects the change of potential difference in the voltage plates.

The proximity of two copper plates creates the sensor part of the remote detector for voltage detection, which sensor part measures the magnitude of the field according to the following formula.

$$E = V / d,$$

wherein E = magnitude of the field
V = voltage generated on the surface of the plates in the electric field [V]
d = distance between the plates [m]

The distance d between the plates in the sensor is constant, but the magnitude of the field varies in relation to the distance from the live electrical conductor. According to the invention, the variable voltage generated on the surface of the plates in the sensor of the remote detector is relative to the distance from a live electrical conductor and the electric field. This voltage of the sensor part is utilised as the input signal of the remote detector apparatus, which signal is processed in the PLC part of the apparatus as presented below.

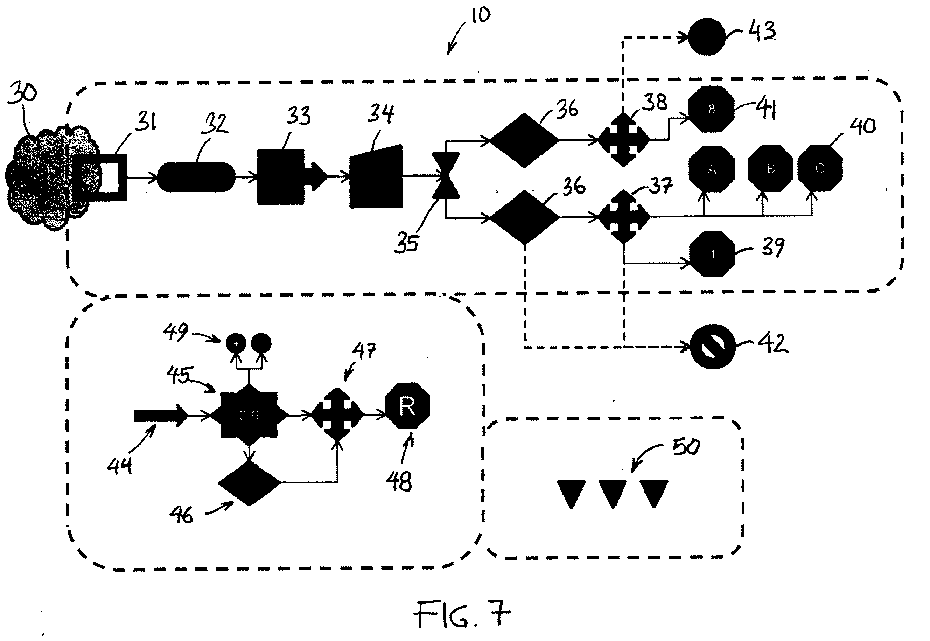

Fig. 7 shows a flowchart of the operation of a remote detector according to the invention, wherein the reference numbers indicate the components relating to the operation of the remote detector. The outlines of the apparatus are shown in Fig. 7 by broken lines, and the flow and processing of the signal is shown in Fig. 7 so that the signal proceeds from left to right.

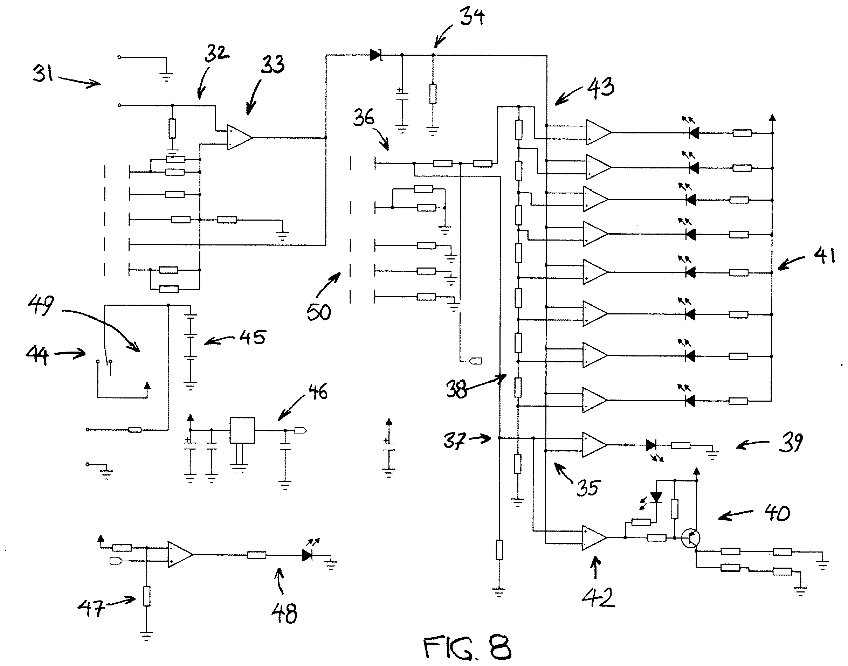

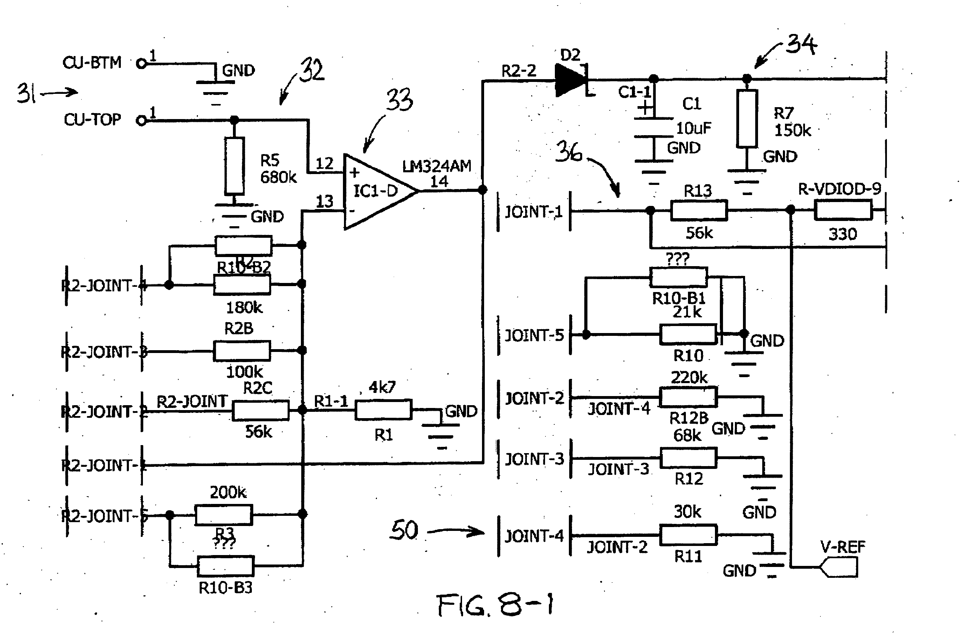

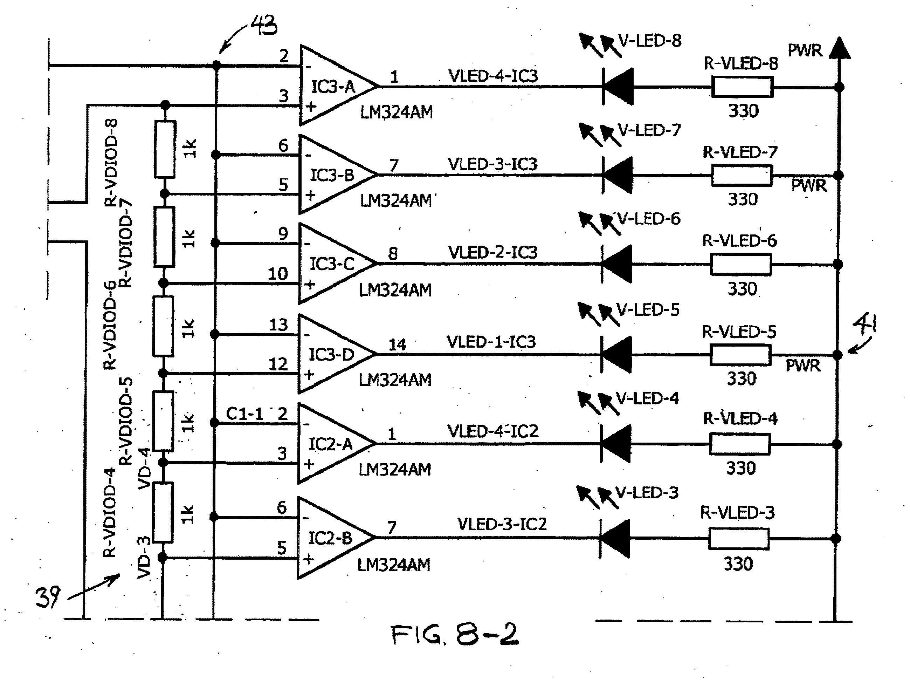

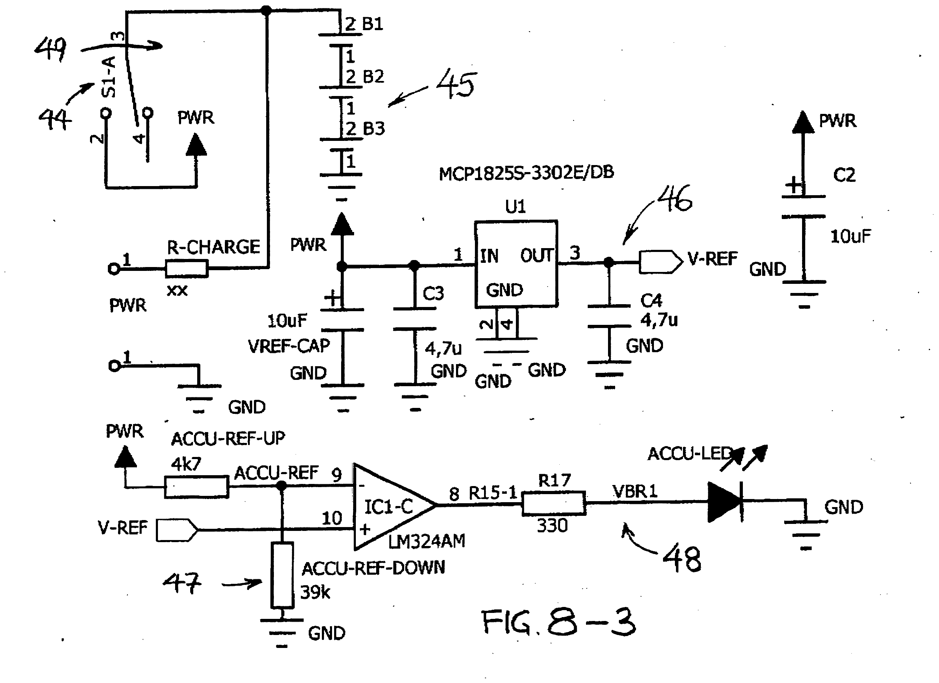

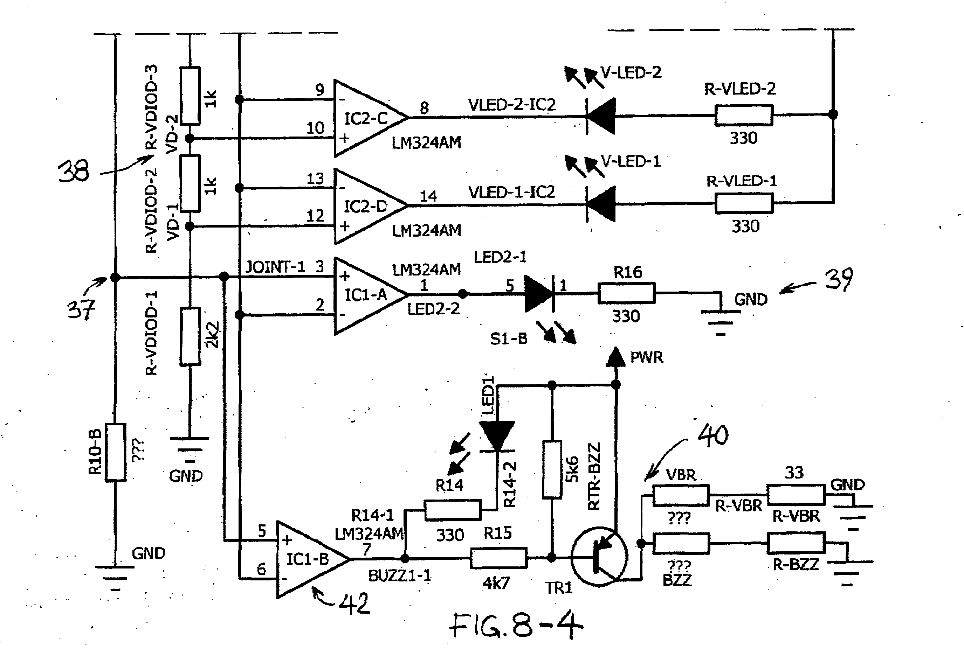

Fig. 8 shows the circuit diagram of a corresponding remote detector, wherein the corresponding parts and functions are marked with the same reference numbers as in Fig. 7. Hereinafter follows a detailed account of the operation of the remote detector, making references both to the flowchart illustrating the operation of the remote detector in Fig. 7 and the circuit diagram in Fig. 8.

The remote detector 10 comprises a sensor 31 comprised of two parallel copper plates. The copper plates are copper surfaces arranged on the both, opposite sides of a circuit board. When the sensor 31 detects an electric field 30 as shown in Fig. 7, a voltage of approximately 10 mV AC is generated on the surface of the copper plates when the line voltage in the high-voltage conductor to be measured is, for example, 110 kV , and the distance to the conductor, for example, approximately 10 m.

The signal generated in the sensor 31 is transmitted as required to a preamplifier and/or matching part 32 of the remote detector apparatus, in which part the input impedance of the signal is modified and the voltage is stabilised by matching. The signal is amplified in an amplifier part 33 using a factor of 40, 35, 25 or 15, for example, depending on the magnitude of the electric field. The amplification power is selected by means of a switch 50 in the apparatus. After this the signal is transmitted to a integration and standardisation part 34 wherein the signal undergoes half-wave rectification. The energy of the signal is collected in a capacitor, the charge of which capacitor is discharged in a continuous mode of 5% within a time range of 0 to 50 ms, which means that the signal can be used in continuous mode and responses are quick, i.e. practically without any delay.

When the alarm of the apparatus is secured, the signal is distributed into two parts in a distribution part 35 between a LED light column 41 and alarms 40. The magnitude of the signal varies depending on the amplification in use, the distance and the electric field. In the example case, the voltage of the signal is approximately 0.5 to 1.5 V when the voltage in the electrical conductor is 110 kV and when measured at a distance of 10 m.

The alarm threshold setting 36 is selected by using the selection switch 50 to select a reference voltage with which voltage the signal level is compared in continuous mode The reference voltages scan the distance to the high-voltage electrical conductor. The alarm thresholds are in fact very accurate, i.e. the difference in the distance from the electrical conductor is approximately 20 cm when the base connection is 14.9 m to 15.1 m, i.e. approx. 15 m, which means that a distance difference of 20 cm amounts to approx. 1.5%. The alarm thresholds are voltage-regulated, and thus decreasing battery voltage does not alter alarm thresholds.

The operation amplifier (op-amp) of the alarm threshold 37 of the main circuit constantly compares the pre-set alarm threshold and the signal level. When the signal exceeds the alarm threshold, the op-amp reduces the output approximately to a value of 0 V, whereby the transistor becomes conductive and the high-power LED, buzzer and vibration alarm receive an operating voltage.

The resistors in series in the alarm threshold 38 in the LED light column 41 formed by the eight LED lights of the apparatus create a seven-step division of voltages. These voltage levels are compared with the signal in continuous mode. When the signal exceeds any of these voltage levels, the op-amp in question lights up the LED light calibrated for indicating that voltage level.

A green LED light located in the power on/off switch 27 in the status indication 39 of the apparatus indicates when the apparatus is in working order. The LED light receives its control signal from the same op-amp amplifier as the main alarm circuit. In other words, if the main alarm circuit is faulty, the apparatus does not indicate that it is in working order.

Three different forms of alarm have been selected for use in alarms 40, the forms of alarm being a high-power LED 23, most advantageously coloured red, a vibration alarm and a buzzer. The LED alarm light 23 is on the bottom in the apparatus of Fig. 2 and on top in the apparatus of Fig. 3. The purpose is to make sure that the user of the apparatus sensorily perceives and notices the alarm in any conditions, even if there is background noise or vibration in the environment, for example when using a chainsaw, or in bright sunshine or complete darkness. It is also possible to use other alarm forms and devices.

The LED lights in the LED light column 41, which lights number eight in the exemplary apparatus shown in Fig. 3, light up according to the strength of the alarm signal. The lowest LED light is yellow and the others are red. The yellow LED light indicates low magnitudes of the field, and it is used for daily testing of the apparatus, for example, in such a way that the apparatus is brought to a distance of approximately 0.01 m from a live 230 VAC electrical conductor. The on-voltages of the LEDs are 0.7 V, 1.0 V, 1.3 V, 1.6 V, 1.9 V, 2.3 V, 2.6 V and 2.9 V. The voltage settings can easily be changed, however, for various applications and needs of the user.

The remote detector also has a control signal outlet 42, which outlet enables using the status indication and alarms of the apparatus as a control impulse for external control. This control signal outlet can be used for the control of any external electro-mechanical apparatuses, such as for controlling a truck bed, the hydraulics of the work platform of a personnel lift or another similar apparatus.

The remote detector also has another control signal outlet 43, by means of which outlet indications and various visualisations outside the apparatus can be controlled, such as a high-power siren, LCD display, digit display or flashing alarm light.

The remote detector comprises a battery 45 having, for example, three batteries of 1.2 V and 400 mAh in series. The size of the batteries and/or the supply of operating voltage can be varied as required.

The battery 45 is recharged via a recharge connector 44 by means of an external recharger, which recharger can, for example, be of a similar type as a regular mobile phone recharger. Most advantageously, the recharger is connected to the remote detector via a Mini-USB connector.

The apparatus also comprises operating voltage reference 46 and an alarm threshold 47 for low voltage, by means of which threshold the battery voltage level can be monitored for voltage regulation. The alarm threshold is voltage-regulated, whereby decreasing battery voltage does not alter alarm thresholds.

Reference number 48 marks the voltage alarm of the battery 45, which alarm indicates the need to recharge the battery as the charge of the battery 45 decreases. In this way the battery 45 can be recharged before the voltage decrease starts to impact the alarm levels of the apparatus.

Reference number 49 marks the operating voltage 49 of the apparatus. The operating voltage and energy of the apparatus has been selected in relation to the operating time and idle currents.

Operating switches 50 are visible outside the remote detector apparatus. The operating switches 50 are used to adjust the amplification 32 of the apparatus and the settings 36 of the alarm thresholds. The amplification 32 and the alarm thresholds 36 can be adjusted by means of separate switches, as shown in Figures 2A and 2B.

However, they can be combined in a single switch such that the amplification 32 and the alarm thresholds 36 function in parallel via a single switch according to pre-calculated signal amplifications and distances from the electrical conductor, as shown in Fig. 3.

A novel, unexpected aspect in the invention is the measuring of the signal in a high-voltage grid without touching the conductor by means of a small and easy-to-use apparatus. Items 31, 32, 33, 34, 36 and 37 in the invention jointly form a new, unexpected totality of operation, making it possible on the whole. Of these, particularly the joint operation of items 31, 32, 33 and 34 form the technological basis of the invention.

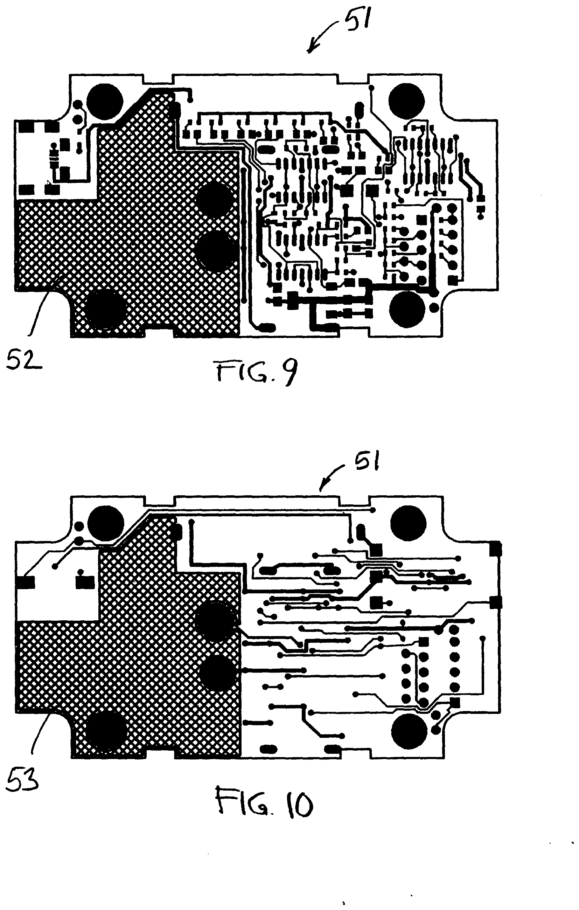

Figures 9 and 10 show the different sides of the circuit board of the remote detector. According to the invention, the sensor is a part of the double-sided circuit board 51 of the apparatus, and the electrically conductive surfaces 52 and 53 on the opposite sides of the same circuit board function as the sensor, the surfaces being of equal size and coated with copper or another electrically conductive material. Fig. 9 shows the first side of the circuit board 51, which part of the circuit board 51 has a copper surface 52. It forms the first plate of the two parallel copper plates of the sensor 31. In the example shown, the copper surface 52 takes up approximately a half of the surface of the circuit board 51. In the example shown, the PLC part of the remote detector apparatus is assembled on the other side of the circuit board 51.

Fig. 10 shows the other side of the circuit board 51, which part of the circuit board 51 also has a copper surface 53. It forms the other plate of the two parallel copper plates of the sensor 31. It is essential in terms of the invention to use as a sensor 31 to indicate the signal the copper surfaces 52 and 53 located at the same point on the opposite sides of a double-sided circuit board 51. The surfaces 52 and 53 forming the copper plates are most advantageously of equal size.

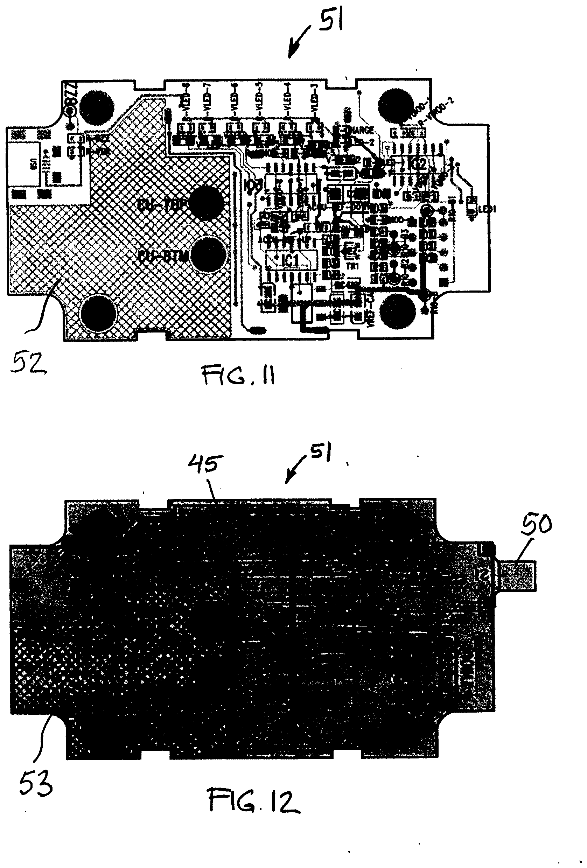

Fig. 11 shows the structure of the remote detector on the first side of the circuit board 51. The apparatus is realised in a compact and simple manner, such that the copper surface 52 functioning as the copper plate of the sensor 31 is at the left end in Fig. 11 of the circuit board 51 and at the opposite end of the circuit board 51 are the small components of the PLC part of the remote detector.

Fig. 12 shows the structure of the remote detector on the other side of the circuit board 51. In this case, at the left end in Fig. 12 of the circuit board 51 is the copper surface 53 functioning as the copper plate of the sensor 31 and at the opposite end of the circuit board 51 are the larger components belonging to the PLC part of the remote detector, such as the battery 45 and the operating switches 50.

Essential here is the compact and robust structure of the remote detector and the entirety of the functionalities. The solution is very simple and durable. It is easy to modify the apparatus according to various needs. On the first side of the circuit board are the electronics of the PLC part, and the battery and the switches are on the other side of the circuit board. The LED light indicators are on the cover of the apparatus enclosure.

The voltage signal in an apparatus according to the invention is transferred after matching into a high-impedance amplifier. Operation of the apparatus is most advantageously based solely on basic electronic components such as a resistor, diode, capacitor, operational amplifier, transistor, LED light, USB connector and, for example, NiCd batteries. The compact and reliable overall design is a key characteristic. To achieve this, the remote detector most advantageously has no computer software. Microprocessors running software would not be reliable in a high-voltage field.

The purpose and significance of the simple structure is to guarantee high reliability of the apparatus in varying conditions. The apparatus can in practice not break down due to excessive voltage in the vicinity of 20 kV to 400 kV electrical grids. The apparatus shown in the example here has all its parts, such as the sensor and the PLC part, in the same enclosure. The components can, however, be relocated to different enclosures to make separate parts when the remote detector is located on a helmet, glove or the tiltable body of a truck, for example. In such a case, it is advantageous to pre-amplify the signal from the sensor and to amplify the alarm signal, for example for programming contactors. Currently known solutions are substantially larger and more cumbersome in field conditions, or they are not readily available.

Furthermore, the circuit board of an apparatus according to the invention is small and robust. It also can be divided into separate parts for various purposes. For example, the sensor part can be integrated in a work helmet or any other device. The PLC part can be placed in the same enclosure with the sensor part or it can be completely separate. Also the enclosure of the apparatus can be modified for different applications and conditions. Most advantageously, the external measurements of the apparatus are 90 mm x 50 mm x 25 mm and the weight of the apparatus is less than 50 g. The power on/off switch 27 protrudes approximately 4 mm out of end when power is switched off. The external surface of the enclosure can be modified and coated freely at the locations that do not cover the sensor area in the circuit board of the apparatus. The apparatus is not vulnerable to scratches, vibration or even rough handling in the field.

It is obvious to a person skilled in the art that the characteristics of a remote detector according to the invention may vary. The essential characteristics of remote detectors according to the invention include, however, the following:

- High-voltage power lines can be measured at a distance without touching the conductor.
- The invention utilises the known phenomenon of capacitance in an inverted manner, in an unexpected way, such that in a relatively large and continuous electric field, a potential difference is generated between the two metal plates close to each other, which potential difference is processed into a significant indication that allows detection of the voltage in the high-voltage conductor.

- As the voltage or the distance between the apparatus and the electrical conductor changes, the change of potential difference in the voltage plates is applied in a novel way as an indication that allows detection of the voltage in the high-voltage conductor.
- The measurement procedure is easy, quick and accurate.
- The size and weight of the apparatus are small, the apparatus is uncomplicated to use, and the cost of manufacturing and using the apparatus is low.
- The apparatus is reliable, and its sensor is in practice unbreakable. The apparatus does not require control calibration or closely monitored conditions.
- The invention is realised without using unreliable software, since a microprocessor could be disturbed by extremely strong electric fields, where the apparatus must operate with absolute reliability.
- The signal indication of the apparatus is not dependent on the current [A] of the power line but rather on the voltage field, whereby in the load on the grid, for example, in 20 kV lines, will not affect the measurement results at all.
- The apparatus has a very wide range of measurements, i.e. from 0.4 to 563 kV line voltage. While the apparatus can measure a line voltage of up to 563 kV and a phase voltage of approximately 325 kV, the working condition of the apparatus can be tested by measuring a phase voltage of no more than 230 V from an ordinary mains wall socket.
- The invention has been tested in laboratory conditions and in practice.
- The apparatus is very useful for professional personnel working on power lines.
- No similar apparatus is available on the market.
- The apparatus makes it possible to significantly improve safety at work, as a small and light measuring apparatus is easy always to carry along, unlike known cumbersome and inconvenient devices.

LIST OF REFERENCE NUMBERS

[0086]

| 1 | 20 kV or 45 kV electrical grid |
| 2 | 110 kV electrical grid |
| 3 | 220 kV electrical grid |
| 4 | 400 kV electrical grid |
| 10 | Remote detector for voltage detection |
| 21 | Voltage selector switch |
| 22 | Sensitivity adjustment switch |
| 23 | LED alarm light |
| 24 | Recharging socket |
| 25 | Green LED light |
| 26 | Red LED light |
| 27 | Power on/off switch |
| 30 | Electric field |
| 31 | Sensor |
| 32 | Preamplifier and/or matching part |
| 33 | Amplifier part |
| 34 | Integration and standardisation part |
| 35 | Signal distribution part |
| 36 | Setting of the alarm threshold |
| 37 | Alarm threshold |
| 38 | Alarm threshold |
| 39 | Status indication of the apparatus |
| 40 | Alarm members |
| 41 | LED light column |
| 42 | Control impulse for external control |
| 43 | Indication externally |
| 44 | Recharging connector |
| 45 | Battery |
| 46 | Voltage reference |
| 47 | Alarm threshold for low battery voltage |

48    Low battery alarm
49    Operating voltage of the apparatus
50    Operating switches
51    Circuit board
52    Copper plate
53    Copper plate

**Claims**

1.  A remote detector (10) for voltage detection in an electrical grid, by means of which remote detector it can be detected whether a voltage is present in an electrical conductor of an electrical grid (1, 2, 3, 4), which remote detector (10) for voltage detection in an electrical grid (1, 2, 3, 4) comprises a sensor (31) with which sensor the voltage of an electrical conductor can be detected at a distance from the electrical conductor without having to touch the electrical conductor, **characterized in**

    - **that** the sensor (31) of the remote detector (10) for voltage detection in an electrical grid (1, 2, 3, 4) comprises two parallel and essentially equally-sized metal surfaces (52, 53) which are arranged on the opposite sides of the same circuit board (31), and between which metal surfaces a signal is generated by the voltage produced in the vicinity of a live high-voltage conductor, by which signal a voltage present in the high-voltage conductor can be detected, and
    - **that** the remote detector (10) for voltage detection is provided with

        - a measuring range for measuring the line voltage of the high-voltage grid,
        - a measuring range for measuring the presence of voltage in an individual conductor or for measuring the phase voltage in a high-voltage grid having several power lines side by side in order to distinguish between live and dead conductors, and
        - a measuring range for testing the apparatus by measuring the phase voltage of an ordinary mains wall socket.

2.  A remote detector (10) for voltage detection according to claim 1, **characterized in**

    - **that** the remote detector (10) and/or the sensor (31) is connected to a piece of electrician's equipment, such as clothing, a glove or a helmet, and
    - **that** the safe distance of the remote detector from the electrical conductor is 1.5 m with voltages of 20 kV, 45 kV or 110 kV, 2 m with voltage of 220 kV and 3.5 m with voltage of 400 kV.

3.  A remote detector (10) for voltage detection according to claim 1, **characterized in**

    - **that** the remote detector (10) and/or the sensor (31) are connected to a vehicle, such as a truck, crane or personnel lift, such that the remote detector gives a safe distance alarm when the vehicle is steered into the vicinity of an electrical conductor, and
    - **that** the safe distance of the remote detector from the electrical conductor is 1.5 m with voltages of 20 kV, 45 kV or 110 kV, 2 m with voltage of 220 kV and 3.5 m with voltage of 400 kV.

4.  A remote detector (10) for voltage detection according to any one of claims 1, 2 or 3, **characterized in in that** the remote detector (10) allows the selection of a suitable voltage and/or sensitivity for establishing the presence of voltage in a high-voltage conductor.

5.  A method for detecting the voltage in an electric conductor of an electrical grid (1, 2, 3, 4), according to the method a remote detector (10) having a voltage detecting sensor (31) is brought into the vicinity of the electrical conductor, at a distance from the electrical conductor, and that by means of the signal provided by the sensor (31) of the remote detector, it is detected at a distance from the electrical conductor whether a voltage is present in the electrical conductor, without having to touch the electrical conductor, **characterized in that**

    - the voltage of the electrical grid (1, 2, 3, 4) is detected by using a remote detector (10) having a voltage detecting sensor (31) comprising two parallel and essentially equally-sized metal surfaces (52, 53), which are arranged on the opposite sides of the same circuit board (31),

- the line voltage of the high-voltage grid (1, 2, 3, 4) is measured by bringing the remote detector (10) into the vicinity of the high-voltage grid in such a way that the distance of the remote detector from the electrical conductor is greater than the required safe distance, which is 1.5 m with voltages of 20 kV, 45 kV or 110 kV, 2 m with voltage of 220 kV and 3.5 m with voltage of 400 kV,
- the presence of voltage in an individual conductor or in a particular phase conductor in the high-voltage grid (1, 2, 3, 4) or in several power lines located side by side is measured Z r by bringing the remote detector (10) into the vicinity of the high-voltage conductor in such a way that the distance of the remote detector from the electrical conductor is greater than the required safe distance, which is 1.5 m with voltages of 20 kV, 45 kV or 110 kV, 2 m with voltage of 220 kV and 3.5 m with voltage of 400 kV, and
- the working condition of the remote detector (10) is tested by measuring the phase voltage of an ordinary mains wall socket.

6. A method according to claim 5, **characterized in that** a voltage in the high-voltage electrical grid (1, 2, 3, 4) is detected and recognised at a distance from the electrical conductor by using the remote detector (10) in such a way that the voltage range of the remote detector is adjusted to correspond to the voltage in the high-voltage conductor.

7. A method according to any one of claims 5 or 6, **characterized in that** a voltage in the high-voltage electrical grid (1, 2, 3, 4) is detected and recognised at a distance from the electrical conductor by using the remote detector (10) in such a way that the sensitivity of the remote detector is adjusted to correspond to the voltage in the high-voltage conductor.

**Patentansprüche**

1. Ein Ferndetektor (10) zur Spannungsfeststellung in einem Stromnetz, mit welchem Ferndetektor festgestellt werden kann, ob an einem elektrischen Leiter eines Stromnetzes (1, 2, 3, 4) eine Spannung anliegt, wobei der Ferndetektor (10) zur Spannungsfeststellung in einem Stromnetz (1, 2, 3, 4) einen Sensor (31) umfasst, mit dem die an einem elektrischen Leiter anliegende Spannung in einem Abstand vom elektrischen Leiter festgestellt werden kann, ohne den elektrischen Leiter berühren zu müssen, **dadurch gekennzeichnet,**

- **dass** der Sensor (31) des Ferndetektors (10) zur Spannungsfeststellung in einem Stromnetz (1, 2, 3, 4) zwei parallele und im Wesentlichen gleich große Metallflächen (52, 53) umfasst, die auf den gegenüberliegenden Seiten derselben Leiterplatte (31) angeordnet sind, und zwischen welchen Metallflächen durch die in der Nähe eines spannungsführenden Hochspannungsleiters erzeugte Spannung ein Signal erzeugt wird, mit dessen Hilfe eine im Hochspannungsleiter anliegende Spannung festgestellt werden kann, und
- **dass** der Ferndetektor (10) zur Spannungsfeststellung verfügt über

- einen Messbereich zur Messung der Leitungsspannung des Hochspannungsnetzes,
- einen Messbereich zur Messung, ob an einem einzelnen Leiter eine Spannung anliegt oder zur Messung der Phasenspannung in einem Hochspannungsnetz mit mehreren nebeneinander verlaufenden Stromleitungen, um zwischen spannungsführenden und spannungslosen Leitern zu unterscheiden, und
- einen Messbereich zum Testen der Vorrichtung durch Messen der Phasenspannung einer gewöhnlichen Netzsteckdose.

2. Ein Ferndetektor (10) zur Spannungsfeststellung nach Anspruch 1, **dadurch gekennzeichnet,**

- **dass** der Ferndetektor (10) und/oder der Sensor (31) an eine Elektrikerausrüstung wie zum Beispiel Kleidung, Handschuh oder Helm angeschlossen ist und
- **dass** der Sicherheitsabstand des Ferndetektors vom elektrischen Leiter bei Spannungen von 20 kV, 45 kV oder 110 kV 1,5 m, bei einer Spannung von 220 kV 2 m und bei einer Spannung von 400 kV 3,5 m beträgt.

3. Ein Ferndetektor (10) zur Spannungsfeststellung nach Anspruch 1, **dadurch gekennzeichnet,**

- **dass** der Ferndetektor (10) und/oder der Sensor (31) so mit einem Transportgerät, wie z. B. einem Lastwagen, Kran oder einer Hebebühne, verbunden sind, dass der Ferndetektor einen Sicherheitsabstandsalarm auslöst, wenn das Transportgerät auf einen elektrischen Leiter zusteuert, und
- **dass** der Sicherheitsabstand des Ferndetektors vom elektrischen Leiter bei Spannungen von 20 kV, 45 kV oder 110 kV 1,5 m, bei einer Spannung von 220 kV 2 m und bei einer Spannung von 400 kV 3,5 m beträgt.

**4.** Ein Ferndetektor (10) zur Spannungsfeststellung nach einem der Patentansprüche 1, 2 oder 3, **dadurch gekennzeichnet, dass** der Ferndetektor (10) die Wahl einer geeigneten Spannung und/oder Feststellungsempfindlichkeit gegenüber einer an einem Hochspannungsleiter anliegenden Spannung ermöglicht.

**5.** Ein Verfahren zur Feststellung der an einem elektrischen Leiter in einem Stromnetz (1, 2, 3, 4) anliegenden Spannung, nach welchem Verfahren ein mit einem Spannungsfeststellungssensor (31) ausgestatteter Ferndetektor (10) in die Nähe eines elektrischen Leiters gebracht wird, wobei ein Abstand zum elektrischen Leiter eingehalten wird, und dass mit Hilfe des vom Sensor (31) des Ferndetektors gelieferten Signals aus einem Abstand vom elektrischen Leiter festgestellt werden kann, ob am elektrischen Leiter eine Spannung anliegt, ohne den elektrischen Leiter berühren zu müssen, **dadurch gekennzeichnet, dass**

- die am Stromnetz (1, 2, 3, 4) anliegende Spannung mit Hilfe eines Ferndetektors (10) festgestellt wird, welcher Ferndetektor mit einem Spannungsfeststellungssensor (31) ausgestattet ist, der zwei parallele und im Wesentlichen gleich große Metallflächen (52, 53) umfasst, die auf den gegenüberliegenden Seiten derselben Leiterplatte (31) angeordnet sind,
- dass die Leitungsspannung des Hochspannungsnetzes (1, 2, 3, 4) dadurch gemessen wird, dass der Ferndetektor (10) so in die Nähe des Hochspannungsnetzes gebracht wird, dass der Abstand des Ferndetektors vom elektrischen Leiter größer ist als der erforderliche Sicherheitsabstand, der bei Spannungen von 20 kV, 45 kV oder 110 kV 1,5 m, bei einer Spannung von 220 kV 2 m und bei einer Spannung von 400 kV 3,5 m beträgt,
- das Anliegen einer Spannung an einem einzelnen Leiter oder an einem bestimmten Phasenleiter des Hochspannungsnetzes (1, 2, 3, 4) oder in mehreren nebeneinander verlaufenden Stromleitungen dadurch gemessen wird, dass der Ferndetektor (10) so in die Nähe des Hochspannungsleiters gebracht wird, dass der Abstand des Ferndetektors vom elektrischen Leiter größer ist als der erforderliche Sicherheitsabstand, der bei Spannungen von 20 kV, 45 kV oder 110 kV 1,5 m, bei einer Spannung von 220 kV 2 m und bei einer Spannung von 400 kV 3,5 m beträgt, und
- der Betriebszustand des Ferndetektors (10) durch Messen der Phasenspannung einer gewöhnlichen Netzsteckdose getestet wird.

**6.** Ein Verfahren nach Patentanspruch 5, **dadurch gekennzeichnet, dass** eine Spannung im Hochspannungsstromnetz (1, 2, 3, 4) so mit Hilfe eines Ferndetektors (10) aus einem Abstand vom elektrischen Leiter festgestellt und erkannt wird, dass der Spannungsbereich des Ferndetektors der am Hochspannungsleiter anliegenden Spannung entsprechend eingestellt wird.

**7.** Ein Verfahren nach einem der Patentansprüche 5 oder 6, **dadurch gekennzeichnet, dass** eine Spannung im Hochspannungsstromnetz (1, 2, 3, 4) so mit Hilfe eines Ferndetektors (10) aus einem Abstand vom elektrischen Leiter festgestellt und erkannt wird, dass die Empfindlichkeit des Ferndetektors der am Hochspannungsleiter anliegenden Spannung entsprechend eingestellt wird.

**Revendications**

**1.** Détecteur à distance (10) pour la détection de la tension sur un réseau électrique, au moyen duquel détecteur à distance on peut détecter si une tension est présente dans un conducteur électrique d'un réseau électrique (1, 2, 3, 4), lequel détecteur à distance (10) pour la détection de la tension sur un réseau électrique (1, 2, 3, 4) comprend un capteur (31) avec lequel capteur la tension d'un conducteur électrique peut être détectée à une distance du conducteur électrique sans avoir à toucher le conducteur électrique, **caractérisé**

- **en ce que** le capteur (31) du détecteur à distance (10) pour la détection de la tension sur un réseau électrique (1, 2, 3, 4) comprend deux surfaces métalliques (52, 53) parallèles et de taille sensiblement identique qui sont disposées sur les côtés opposés du même circuit imprimé (31), et entre lesquelles surfaces métalliques un signal est généré par la tension produite à proximité d'un conducteur haute tension sous tension, signal par lequel une tension présente dans le conducteur haute tension peut être détectée, et
- **en ce que** le détecteur à distance (10) pour la détection de la tension est muni

- d'une plage de mesure pour mesurer la tension de ligne du réseau haute tension,
- d'une plage de mesure pour mesurer la présence de tension dans un conducteur individuel ou pour mesurer la tension de phase sur un réseau haute tension comportant plusieurs lignes électriques côte à côte afin de distinguer les conducteurs sous tension des conducteurs hors tension, et

- d'une plage de mesure permettant de tester l'appareil en mesurant la tension de phase d'une prise murale ordinaire.

2. Détecteur à distance (10) pour la détection de la tension selon la revendication 1, **caractérisé**

- **en ce que** le détecteur à distance (10) et/ou le capteur (31) est relié à un équipement d'électricien, tel qu'un vêtement, un gant ou un casque, et
- **en ce que** la distance de sécurité entre le détecteur à distance et le conducteur électrique est de 1,5 m avec des tensions de 20 kV, 45 kV ou 110 kV, de 2 m avec une tension de 220 kV et de 3,5 m avec une tension de 400 kV.

3. Détecteur à distance (10) pour la détection de la tension selon la revendication 1, **caractérisé**

- **en ce que** le détecteur à distance (10) et/ou le capteur (31) sont reliés à un véhicule, tel qu'un camion, une grue ou un monte-charge, de telle sorte que le détecteur à distance émette une alarme de distance de sécurité lorsque le véhicule est dirigé à proximité d'un conducteur électrique, et
- **en ce que** la distance de sécurité entre le détecteur à distance et le conducteur électrique est de 1,5 m avec des tensions de 20 kV, 45 kV ou 110 kV, de 2 m avec une tension de 220 kV et de 3,5 m avec une tension de 400 kV.

4. Détecteur à distance (10) pour la détection de la tension selon l'une quelconque des revendications 1, 2 ou 3, **caractérisé en ce que** le détecteur à distance (10) permet la sélection d'une tension et/ou d'une sensibilité appropriées pour établir la présence de tension dans un conducteur haute tension.

5. Procédé pour détecter la tension dans un conducteur électrique d'un réseau électrique (1, 2, 3, 4), selon le procédé, un détecteur à distance (10) ayant un capteur de détection de tension (31) est amené à proximité du conducteur électrique, à une distance du conducteur électrique, et qu'au moyen du signal fourni par le capteur (31) du détecteur à distance, la présence d'une tension dans le conducteur électrique est détectée à une distance du conducteur électrique, sans avoir à toucher le conducteur électrique, **caractérisé en ce que**

- la tension du réseau électrique (1, 2, 3, 4) est détectée en utilisant un détecteur à distance (10) ayant un capteur de détection de tension (31) comprenant deux surfaces métalliques (52, 53) parallèles et de taille sensiblement identique, qui sont disposées sur les côtés opposés du même circuit imprimé (31),
- la tension de ligne du réseau haute tension (1, 2, 3, 4) est mesurée en amenant le détecteur à distance (10) à proximité du réseau haute tension de manière à ce que la distance entre le détecteur à distance et le conducteur électrique soit supérieure à la distance de sécurité requise, qui est de 1,5 m avec des tensions de 20 kV, 45 kV ou 110 kV, de 2 m avec une tension de 220 kV et de 3,5 m avec une tension de 400 kV,
- la présence de tension dans un conducteur individuel ou dans un conducteur de phase particulier du réseau haute tension (1, 2, 3, 4) ou dans plusieurs lignes électriques situées côte à côte est mesurée en amenant le détecteur à distance (10) à proximité du conducteur haute tension de telle sorte que la distance entre le détecteur à distance et le conducteur électrique soit supérieure à la distance de sécurité requise, qui est de 1,5 m avec des tensions de 20 kV, 45 kV ou 110 kV, de 2 m avec une tension de 220 kV et de 3,5 m avec une tension de 400 kV, et
- l'état de fonctionnement du détecteur à distance (10) est testé en mesurant la tension de phase d'une prise murale ordinaire.

6. Procédé selon la revendication 5, **caractérisé en ce qu'**une tension sur le réseau électrique haute tension (1, 2, 3, 4) est détectée et reconnue à une distance du conducteur électrique en utilisant le détecteur à distance (10) de telle sorte que la plage de tension du détecteur à distance soit ajustée pour correspondre à la tension dans le conducteur haute tension.

7. Procédé selon l'une quelconque des revendications 5 ou 6, **caractérisé en ce qu'**une tension sur le réseau électrique haute tension (1, 2, 3, 4) est détectée et reconnue à une distance du conducteur électrique en utilisant le détecteur à distance (10) de telle sorte que la sensibilité du détecteur à distance soit ajustée pour correspondre à la tension dans le conducteur haute tension.

FIG.1

22    21

10

0 = OFF   1 = 20 kV/TEST
2 = 110 kV   3 = 400 kV

26    10

22    21

25

FIG.2B

23    FIG.2A    24

50

27    23

10

41

26

44

FIG.3

FIG.4

FIG.5

FIG.6A

FIG.6B

FIG. 7

FIG. 8

FIG. 8-1

FIG. 8-2

FIG. 8-3

EP 2 746 784 B1

FIG.8-4

FIG. 9

FIG. 10

51

52

FIG. 11

45    51

50

53

FIG. 12

**REFERENCES CITED IN THE DESCRIPTION**

**Patent documents cited in the description**

- WO 9859251 A
- DE 2418622 A1
- US 5859597 A
- US 3296494 A
- US 3546587 A
- DE 2846674 A1